(19) **Europäisches Patentamt**

**European Patent Office**

**Office européen des brevets**

(11) **EP 1 204 148 A2**

(12) **EUROPEAN PATENT APPLICATION**

(43) Date of publication:
08.05.2002 Bulletin 2002/19

(51) Int Cl.⁷: **H01L 31/105**, H01L 31/107,
H01L 31/0232

(21) Application number: 01308795.2

(22) Date of filing: 16.10.2001

(84) Designated Contracting States:
**AT BE CH CY DE DK ES FI FR GB GR IE IT LI LU
MC NL PT SE TR**
Designated Extension States:
**AL LT LV MK RO SI**

(30) Priority: **06.11.2000 US 707124**

(71) Applicant: **Agere Systems Optoelectronics
Guardian Corporation
Orlando, Florida (US)**

(72) Inventor: **Onat, Bora M.
Macungie, PA 18062 (US)**

(74) Representative:
**McLeish, Nicholas Alistair Maxwell et al
Boult Wade Tennant
Verulam Gardens
70 Gray's Inn Road
London WC1X 8BT (GB)**

(54) **Planar resonant cavity enhanced photodetector**

(57) A planar-type, bottom-illuminated resonant cavity enhanced (RCE) photodetector is provided. A resonant cavity with a first mirror and a second mirror is disposed within a planar-type, bottom-illuminated photodetector. The light-absorbing layer of the bottom-illuminated, planar type photodetector is sandwiched between the first mirror and the second mirror of the resonant cavity structure of the photodetector. At least one of the first mirror and the second mirror of the resonant cavity is made from a high reflectivity metal such as gold or silver instead of a Distributed Bragg Reflector (DBR) thereby simplifying the fabrication process. This device combines the excellent reliability capabilities of a planar diode with a high bandwidth and quantum efficiency resonant cavity enhanced photodetector. Yet the device processing is robust enough for high manufacturing volumes.

Figure 2.
RCE p-i-n photodiode

**EP 1 204 148 A2**

**Description**

BACKGROUND OF THE INVENTION

This invention relates to photodetectors and, more particularly, to a planar resonant cavity enhanced photodetector.

High-speed, high-efficiency photodetectors are vital components of optical communication systems. The optimized structure of high-bandwidth photodetectors typically requires a thin absorption region to reduce the transit time of the created carriers. However, the thin absorption region also reduces the efficiency of light absorption compromising the performance of the photodetectors.

In photodetectors, quantum efficiency indicates the probability that a single photon incident on the device generates an electron-hole pair which contributes to the detector current. The responsivity, an output per unit input of a detector, is calculated from the quantum efficiency. To increase the responsivity of photodetectors with a thin absorption region, so-called resonant cavity enhanced (RCE) photodetectors have been used. RCE photodetectors employ an optical resonator, Fabry-Perot cavity, in which light incident on the device is trapped by the two parallel mirrors. The light absorbing layer of an RCE photodetector is placed within the mirrors of a resonant cavity ensuring multiple passes of light through the absorption region, increasing the quantum efficiency.

In addition to enhancing the photosensitivity at the desired wavelength, an RCE photodetector also provides wavelength selectivity since all the off-resonance wavelengths of the light source are rejected by the cavity. This selectivity of frequency range enables the RCE photodetectors to be a promising candidate for low crosstalk wavelength division multiplexing (WDM) applications.

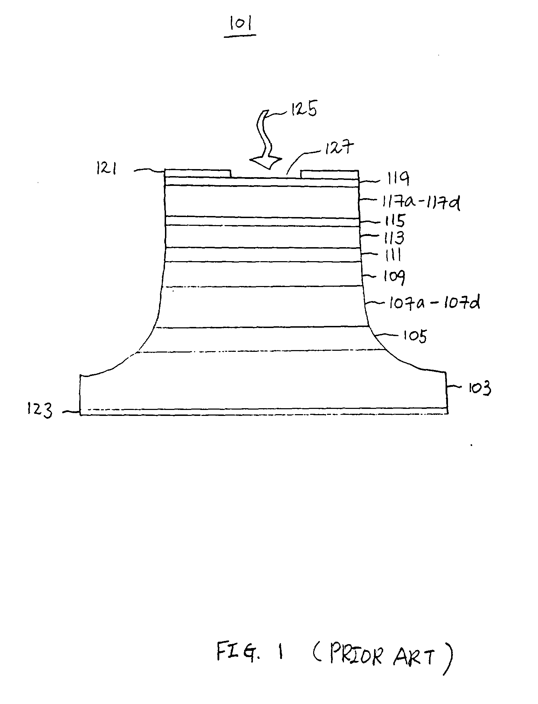

Fig. 1 is a cross-sectional view of a typical RCE p-i-n photodetector 101 in which a mesa-type, top-illuminated structure is used. Photodetector 101 comprises Indium Phosphide (InP) substrate 103, n-type buffer layer 105, Distributed Bragg Reflector (DBR) 107a-107d, light absorption layer 111 sandwiched between two non-absorbing layers 109 and 113, p- type semiconductor layer 115, DBR 117a-117d and window layer 119. DBR 107a-107d acts as a bottom mirror R2, while DBR 117a-117d acts as a top mirror R1. First and second electrodes 121, 123 are formed adjacent to window layer 119 and substrate 103, respectively.

Light 125 from a light source (not shown) is introduced from surface window 127 of photodetector 101. Light 125 penetrates window layer 119, DBR 117a-117d, p-layer 115, non-absorbing layer 113 and reaches the light absorption layer 111. As a result, electron-hole pairs are created at absorption layer 111. Light 125 then proceeds and bounces back at DBR 107a-107d. Light 125 bounces back and forth between DBR 107a-107d and DBR 117a-117d, creating additional electron-hole pairs at each pass at light absorption layer 111. The electrons and holes created in layer 111 are collected at electrodes 121 and 123 and supplied to an outside circuit (not shown).

Mesa-type, top-illuminated RCE photodetectors are currently widely in use. However, there is still a need for improved performance in RCE photodetectors.

SUMMARY OF THE INVENTION

In accordance with an aspect of this invention, there is provided a planar-type, bottom-illuminated RCE photodetector. A resonant cavity with a first mirror and a second mirror is disposed within a planar-type, bottom-illuminated photodetector. A light-absorbing layer of the planar-type, bottom-illuminated photodetector is sandwiched between the first mirror and the second mirror of the resonant cavity.

In accordance with another aspect of this invention, at least one of the first mirror and the second mirror of the resonant cavity is made from a high reflectivity means. A metal such as gold or silver, instead of a DBR, may be utilized in bottom-illuminated photodetectors, simplifying the fabrication process. The planar-type photodetectors have an added advantage of very good reliability with respect to the mesa-type photodetectors since good surface passivation, which dictates the device reliability, is difficult for mesas. Moreover, a planar-type wave-guide can be formed right on top of the electrode.

It is not intended that the invention be summarized here in its entirety. Rather, further features, aspects and advantages of the invention are set forth in or are apparent from the following description and drawings.

BRIEF DESCRIPTION OF THE DRAWINGS

Fig. 1 is a view of a conventional RCE p-i-n photodetector 101;
Fig. 2 is a cross-sectional view of planar-type, bottom-illuminated RCE p-i-n photodetector 201 according to the invention;
Fig. 3 is a graph of the calculated quantum efficiency versus wavelength for a photodetector constructed in accordance with the present invention; and
Fig. 4 shows another example of the present invention, i.e. planar-type, bottom illuminated RCE avalanche photo diode (APD) 301.

DETAILED DESCRIPTION

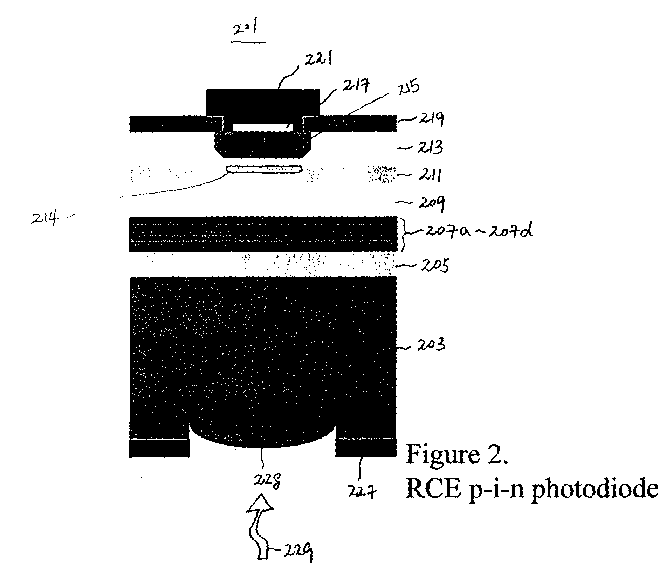

Fig. 2 shows in cross-section a preferred embodiment of the photodetector 201 of the present invention. Photodetector 201 has a planar-type and bottom-illuminated structure. For illustration purposes, various dimensions of the device are not shown to scale in Fig. 2.

Photodetector 201 comprises n-doped InP substrate 203, buffer layer 205, DBR 207a-207d, absorption layer 211 sandwiched between non-absorbing (wide band-gap) layers 209 and 213, $p^+$ semiconductor layer 215 and top reflecting layer 217. Photodetector 201 further comprises passivation layer 219, and $p^+$ metal contact layer 221. $N^+$ metal contact layer 227 is formed on the other side of InP substrate 203. DBR 207a-207d acts as a first mirror R1, while top reflecting layer 217 acts as a top mirror R2 of the cavity structure.

The fabricating process of photodetector 201 is now described.

Although a plurality of photodetectors are fabricated on a wafer in a real process, the singular will be used to describe one such device for clarity and simplicity. The materials, dimensions, and other processing methods are provided by way of illustration only and are not intended to be limitations on the scope of the invention.

Photodetector 201 is built on n-type InP substrate 203 normally doped with Sulfur. The thickness of the substrate is about 100 μm. One side of substrate 203 can be shaped as a lens 228 to focus light 229 more effectively. The epitaxial layers 205, 207a-207d, 209, 211 and 213 can be deposited by any commonly used epitaxy techniques such as LPE (liquid phase epitaxy), MOCVD (metal organic chemical vapor deposition) or MBE (molecular beam epitaxy). Preferably, all epitaxial layers 205, 207a-207d, 209, 211 and 213 are deposited sequentially without breaking the vacuum of the deposition equipment to thereby enhance the film quality of the layers.

Buffer layer 205 comprises InP with a thickness of about 0.5 μm. It is formed on top of substrate 203 in order to mitigate lattice mismatch between substrate 203 and the semiconductor layers to be formed. Buffer layer 205 also reduces impurity diffusion from substrate 203 into the upper semiconductor layers.

Four epitaxial layers are then formed for DBR 207a-207d by depositing layers of contrasting refractive indices. The material of each layer, their respective indices of refraction, and the number of layers are determined to provide a desired reflectivity for the mirror function of DBR 207a-207d of photodetector 201. In a preferred embodiment, a InP/InGaAs/InP/InGaAs combination is used for DBR 207a-207d and each of the layers is about 0.12 μm in thickness, providing a reflectivity of about 35%.

On top of DBR 207a-207d, an InGaAsP wide band-gap layer 209, an InGaAs absorption layer 211, and an InGaAsP wide band-gap layer 213 are deposited. In a preferred embodiment, the thickness of the layers 209, 211 and 213 is respectively 0.7 μm, 0.7 μm and 0.25 μm.

Passivation layer 219 is formed covering the entire top surface of wide band-gap layer 213. In a preferred embodiment, a 3000 Å-thick $SiN_x$ is deposited on top of wide gap layer 213 using PECVD (plasma-enhanced chemical vapor deposition).

Subsequently, an opening is formed in passivation layer 219 by etching a predetermined portion of the layer using a photolithography process. The opening is a space for Zn diffusion to form $p^+$ layer 215. The diffusion process, for example, can be done at 550 °C for 90 minutes in an ampoule. The duration time for the diffusion may be adjusted for an appropriate thickness of $p^+$ layer 215.

The $p^+$ metal contact 221 is then deposited on the opening by an appropriate processing method such as electron beam evaporation. $P^+$ metal contact 221 itself also has an opening at the center where top reflecting layer 217 is formed at a later processing step.

After the deposition of $p^+$ metal contact layer 221, the whole device is exposed to a heat treatment at about 420 °C for one minute. Thus, an ohmic contact is also formed between $p^+$ metal contact layer 221 and $p^+$ layer 215.

Subsequently, top reflecting layer 217 is deposited on the opening of $p^+$ metal contact layer 221. Metal with high reflectivity such as gold or silver can be used for top reflecting layer 217. Alternatively, other materials such as insulators and semiconductors, used to deposit a DBR of alternating dielectrics may be used to form reflecting layer 217. For example, a $SiO_2$, $Si_3N_4$ DBR may be deposited via PECVD method.

The lens 228 on the surface of substrate 203 is formed by photoresist processing followed by selective dry-etch of the InP substrate 203. The $n^+$ contact metal layer 227 is finally deposited around the lens area of substrate 203, completing the fabrication process of photodetector 201.

Photodetector 201 has several advantages resulting from its planar and bottom-illuminated nature. The bottom-illuminated structure of photodetector 201 results in simpler device fabrication and greater device reliability. For example, top reflecting layer 217 can be a simple metal layer rather than the multiple layers of a DBR, because light 229 does not need to be transmitted through the top mirror. Also, compared to the complex epitaxial processing of a DBR, the fabrication process of a metal layer is simple and less expensive.

The planar-type structure of photodetector 201 is also advantageous. First, planar passivation layer 219 can be readily applied to wide band-gap layer 213, so that the semiconductor layers underneath are passivated. Secondly, planar processing enables wide band-gap layer 213 to act as a capping layer, so that the p-n junction touches the device surface in a relatively wide-bandgap material, rather than low-bandgap absorption layer 211. Thus, photodetector 201 shows relatively low thermally stimulated leakage (dark current), and reduced leakage from surface states. This design also produces very good high speed carrier transport characteristics. A co-planar waveguide may also be formed on top of the p⁺ metal contact layer 221 to propagate the optical signal.

The operation of planar-type, bottom-illuminated photodetector 201 described below is only illustrative and not limiting. Light 229 which has a wavelength of 1.55 μm is introduced from bottom surface window 228 of photodetector 201. Light 229 penetrates substrate 203, buffer layer 205, DBR 207a-207d and wide band-gap layer 209 in order. InP substrate 203, InP buffer layer 205, InP/InGaAs DBR 207a-207d and InGaAsP wide gap layer 209 are relatively transparent to light with a 1.55 μm wavelength because of their wide band-gap. Light 229 then reaches and is absorbed at absorption layer 211. As a result, electron-hole pairs are generated at absorption layer 211. The generated electron-hole pairs are separated at the negatively-biased junction 214 and collected at electrodes 221, 227. The remaining light 229 continues to travel up to top reflecting layer 217. The light 229 then bounces back and forth between top reflecting layer 217 and DBR 207a-207d creating additional electron-hole pairs at absorption layer 211 at each pass. Again, the generated electron-hole pairs are collected at electrodes 221, 227. The collected carriers are supplied to an outside circuit such as an amplifier (not shown) for further processing as a photo-current signal.

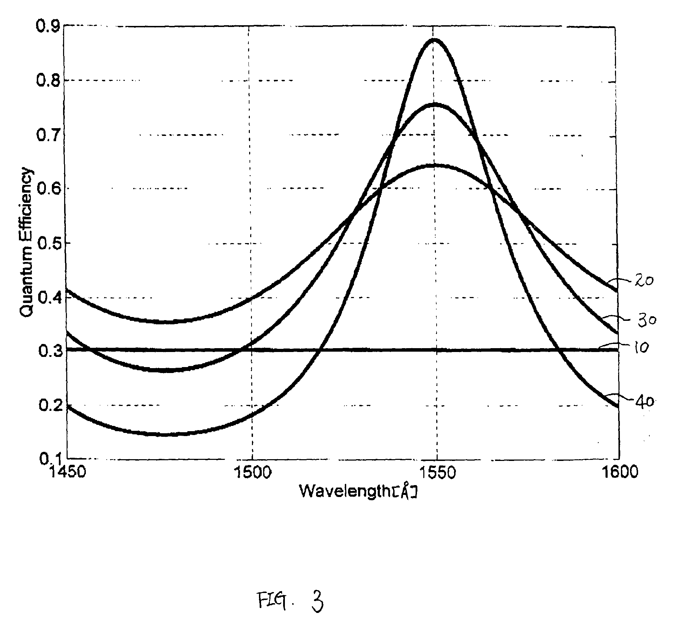

Figure 3 is a graph showing the calculated quantum efficiency vs. wavelength for a photodetector 201 constructed in accordance with the present invention. It is assumed that the absorption coefficient of absorption layer 211 and the reflectivity of reflecting layer 217 are $0.36 \times 10^4$ cm⁻¹ and 0.9, respectively. It is also assumed that there is no absorption in the cavity of photodetector 201 other than the absorbing layer 211.

Each of the curves 10, 20, 30, 40 of Fig. 3 represent different quantum efficiencies of photodetector 201. It has been calculated that for the operation wavelength of 1550 nm, the required reflectivities of DBR 207a-207d are 0, 0.05, 0.15 and 0.4 to achieve quantum efficiencies of 30 %, 65 %, 75 % and 87 %, in curves 10, 20, 30 and 40, respectively. In other words, a relatively high quantum efficiency is achieved with a relatively low reflectivity of DBR 207a-207d. Typically, a few stacks of alternating layers of DBR 207a-207d are necessary to achieve such reflectivities.

The transit time-limited bandwidth of photodetector 201 has been calculated as 50 GHz at 1.55 μm wavelength, using the following formula:

$$f = 0.45 \, Vp/Ln$$

where Vp and Ln indicate hole velocity and the average distance that holes traveled, respectively. It is assumed that hole velocity and the average distance that holes traveled are $4.8 \times 10^6$ cm/s and 0.43 μm, respectively. It is also assumed that the absorption coefficient and absorption region thickness product is 0.36 for the calculation of Vp and Ln.

Although an embodiment has been discussed with a p-i-n photodetector, in other embodiments, other types of photodetectors such as a p-n photodetector or an avalanche photodetector (APD) may be used.

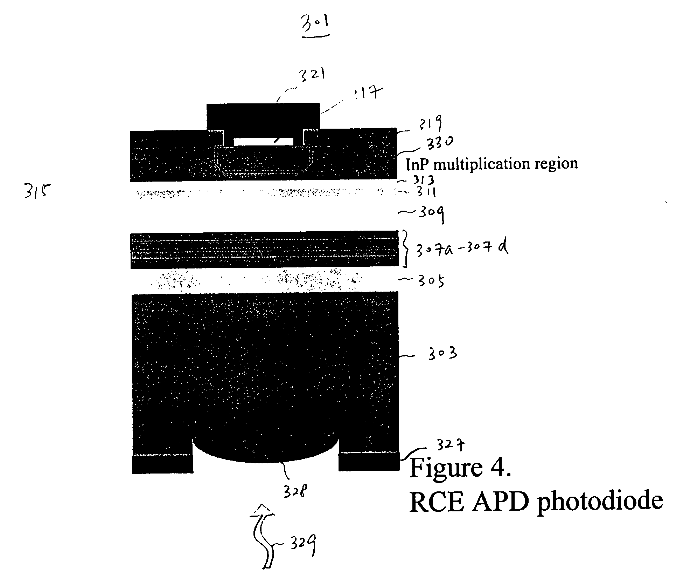

Fig. 4 shows another example of the present invention, i.e. planar-type, bottom illuminated RCE avalanche photo diode (APD) 301. The basic structure of the APD 301 is similar to the photodiode 201. The APD 301 includes an absorption layer 311 which is sandwiched between the two non-absorbing layers 309, 313. The DBR layers 307a-307d and reflecting layer 317 are acting as the bottom and top mirrors, respectively. In the APD 301, however, an InP cap layer 330 is located on top of the non-absorbing layer 313 and the p⁺ layer 315 is within the InP cap layer 330.

Although illustrative embodiments of the present invention, and various modifications thereof, have been described in detail herein with reference to the accompanying drawings, it is to be understood that the invention is not limited to these precise embodiments and the described modifications, and that various changes and further modifications may be effected therein by one skilled in the art without departing from the scope or spirit of the invention as defined in the appended claims.

**Claims**

1. A planar type back-illuminated photo-detecting device, comprising:

   a first electrode;
   a first mirror;
   a first-type conductivity region;
   a light absorbing region;
   a second mirror forming a resonant cavity with said first mirror and said light absorbing region disposed within said resonant cavity;
   a semiconductor body of a second-type conductivity that is substantially transparent to light to be detected; and
   a second electrode to said semiconductor body configured to permit said light to be incident on said semiconductor body.

2. The photo-detecting device according to claim 1, wherein said first mirror is made from a single layer of a highly reflective material.

3. The photo-detecting device according to claim 2, wherein said highly reflective material is a metal.

4. The photo-detecting device according to claim 3, wherein said metal is one of silver, aluminum or gold.

**5.** The photo-detecting device according to claim 2, wherein said highly reflective material is made from a group consisting of insulator, semiconductor, metal or in combination of at least two of the insulator, semiconductor and metal.

**6.** The photo-detecting device according to claim 1, wherein said first-type conductivity is P-type and said second-type conductivity is N-type.

**7.** The photo-detecting device according to claim 1, wherein said first-type conductivity is N-type and said second-type conductivity is P-type.

**8.** The photo-detecting device according to claim 1, wherein said light-absorbing region is sandwiched between two wide gap regions that are substantially transparent to said light to be detected.

**9.** The photo-detecting device according to claim 1, wherein said planar type back-illuminated photo-detecting device is selected from a group consisting of a PN photodetector, a PIN photodetector and an avalanche photodetector.

**10.** The photo-detecting device according to claim 1, wherein each of said first-type conductivity region, said light absorbing region and said semiconductor body is made from a group consisting any one of III-V compound semiconductors, Si or Ge.

**11.** A planar, back-illuminated photodiode comprising:

a semiconductor body of one conductivity type which is transparent to lightwaves to be detected;
a first electrical contact to said body adapted to permit said lightwaves to be incident on said body;
a first mirror of a cavity structure formed on the top of said body remote from said first electrical contact and adapted to permit said lightwaves to be transmitted;
a light-absorbing layer of said one conductivity type formed over said first mirror so as to absorb said lightwaves which are transmitted through said first mirror, thereby to generate electrons and holes in said light-absorbing layer;
a cap layer of said one conductivity type formed on the top of said light-absorbing layer remote from said first mirror and having a wider bandgap than said light-absorbing layer;
a zone of opposite conductivity type extending into said cap layer, thereby to form a junction for collecting said electrons and holes and generating a photocurrent;
a second mirror of the cavity structure formed on said zone adapted to reflect said lightwaves; and
a second electrical contact to said zone.

**12.** The planar, back-illuminated photodiode of claim 11, wherein said first mirror is a Distributed Bragg Reflector (DBR).

**13.** The planar, back-illuminated photodiode of claim 12, wherein said DBR is composed of multiple semiconducting layers.

**14.** The planar, back-illuminated photodiode of claim 11, wherein said second mirror is a high-reflective metal selected from a group consisting of a gold, silver or aluminum.

**15.** The planar, back-illuminated photodiode of claim 11, wherein said second mirror is a dielectric material selected from a group consisting of a silicon nitride or silicon oxide .

**16.** The planar, back-illuminated photodiode of claim 11, wherein said second mirror is a semiconductor material selected from a group consisting of a GaAs, InP, insulator, metal or in combination of at least two of the GaAs, InP, insulator and metal.

**17.** The planar, back-illuminated photodiode of claim 11, wherein said second electrical contact is configured to include said second mirror.

**18.** The planar, back-illuminated photodiode of claim 11, wherein said first-type conductivity is N-type and said second-type conductivity is P-type.

**19.** The planar, back-illuminated photodiode of claim 11, wherein said first-type conductivity is P-type and said second-type conductivity is N-type.

**20.** The planar, back-illuminated photodiode of claim 11, wherein said planar, back-illuminated photodiode is selected from a group consisting of a PN photodetector, a PIN photodetector and an avalanche photodetector (APD).

**21.** The photo-detecting device according to claim 11, wherein said light-absorbing layer is sandwiched between two wide gap regions that are substantially transparent to said light to be detected.

101

125

127

121

119

117a-117d

115

113

111

109

107a-107d

105

103

123

FIG. 1 (PRIOR ART)

Figure 2.
RCE p-i-n photodiode

EP 1 204 148 A2

FIG. 3

InP multiplication region

Figure 4.
RCE APD photodiode

EP 1 204 148 A2